# EUROPEAN PATENT APPLICATION

(11) **EP 4 633 330 A1**
(43) Date of publication of application: **15.10.2025**
(21) Application number: 25166849.7
(22) Date of filing: 27.03.2025
(51) Int. Cl.: H10H 20/856, H10H 29/856

(54) **DISPLAY DEVICE**

(30) Priority: 08.04.2024 JP 2024061939
(71) Applicant: Alps Alpine Co., Ltd., Ota-ku, Tokyo 145-8501 (JP)
(72) Inventor: Kishida, Katsuhiko, Iwaki-city Fukushima (JP)
(74) Representative: Schmitt-Nilson Schraud Waibel Wohlfrom Patentanwälte Partnerschaft mbB

(57) **Abstract**

A display device includes a substrate, a plurality of interconnects disposed on the substrate, and a plurality of light-emitting elements arranged on the substrate and electrically connected to the plurality of interconnects. The plurality of light-emitting elements include a red light-emitting element configured to emit red light, a green light-emitting element configured to emit green light, and a blue light-emitting element configured to emit blue light. A wall is provided around a light-emitting element selected from the red light-emitting element, the green light-emitting element, and the blue light-emitting element, so as to control light emitting from the selected light-emitting element.

## Description

The present disclosure relates to a display device including a plurality of light-emitting elements formed on a substrate, and particularly to a display device including micro light-emitting diodes (LEDs).

In recent years, micro LEDs that can display images directly from light-emitting diodes have been developed. The micro LEDs are two-dimensionally arranged to correspond to pixels. For color images, each pixel includes blue, green, and red sub-pixels.

For example, JP 2021-504752 A describes a passive drive display LED stack. In the passive drive display LED stack, a first red (R) LED stack, a second green (G) LED stack, and a third blue (B) LED stack are vertically stacked, anodes of light-emitting diodes of the first LED stack to the third LED stack are connected to a common data line, cathodes of the light-emitting diodes are connected to scan lines 1, 2, and 3, respectively, and the R, G, and B light-emitting diodes in the same pixel are driven independently of each other.

US 11,171,270 B1 describes an active drive micro LED. In the active drive micro LED, a thin-film transistor (TFT) including a gate electrode, a drain electrode, and a source electrode is formed on a semiconductor layer, a planarization layer is formed so as to cover the TFT, a first electrode is formed on the planarization layer so as to be connected to a source electrode via a via hole of the planarization layer, and an LED is formed between the first electrode and a second electrode that is formed above the first electrode.

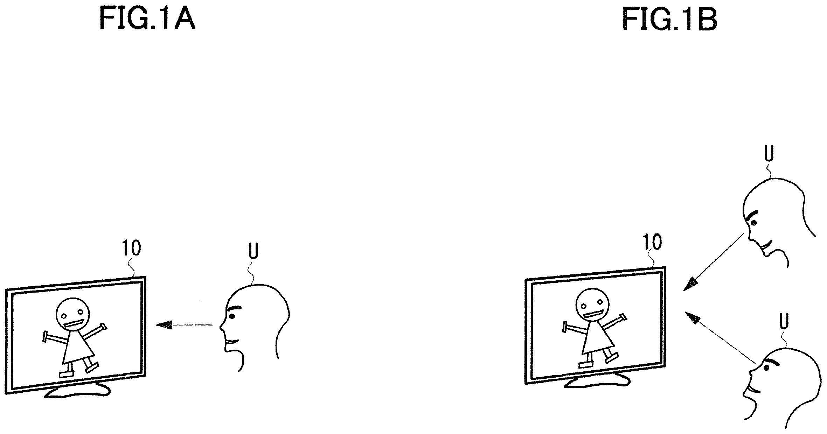

In a display using micro LEDs, the color changes according to the viewing angle. For example, as illustrated in FIG. 1A, when a user U views a display 10 from the front, a clear image can be seen. However, as illustrated in FIG. 1B, when the user U views the display 10 from above or below, the image looks more blue and green.

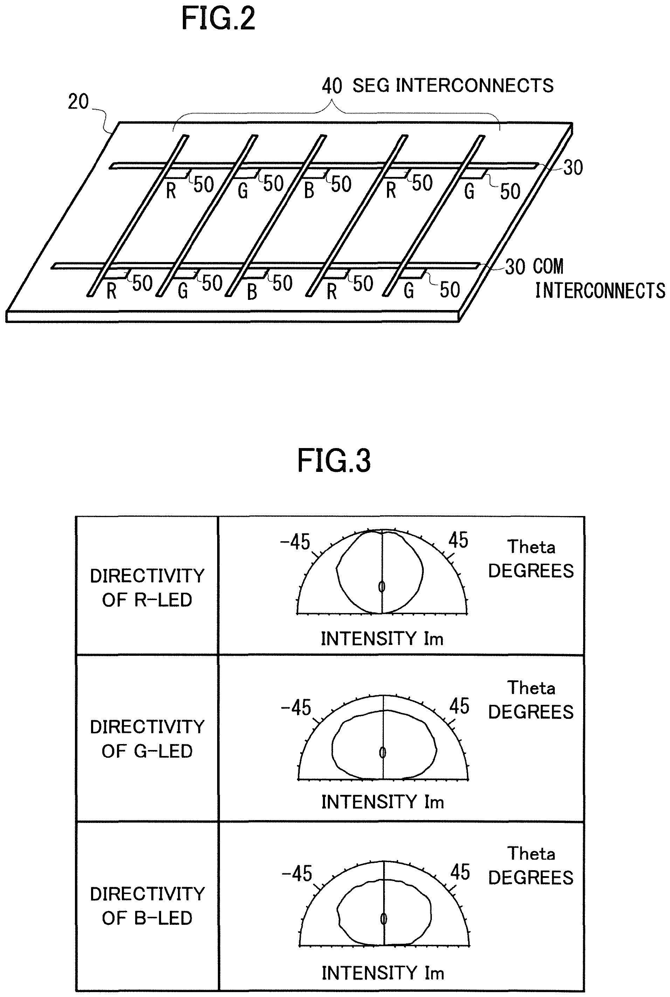

FIG. 2 is a schematic perspective view of a substrate on which micro LEDs are mounted. As illustrated in FIG. 2, COM interconnects 30 are formed in the row direction and SEG interconnects 40 are formed in the column direction on a substrate 20, and micro LEDs 50 are mounted at intersections of the matrix. The micro LEDs 50 includes R, G, and B LED chips. For example, in passive driving, the SEG interconnects 40 are driven in a time-division manner at a constant frequency, and a driving current corresponding to an image signal is applied from the SEG interconnects 40 to the COM interconnects 30 such that each of the micro LEDs 50 emits light.

The present disclosure relates to a display device according to the appended claims. Embodiments are disclosed in the dependent claims.

A display device according to one embodiment of the present disclosure includes a substrate; a plurality of interconnects disposed on the substrate; and a plurality of light-emitting elements arranged on the substrate and electrically connected to the plurality of interconnects. The plurality of light-emitting elements include a red light-emitting element configured to emit red light, a green light-emitting element configured to emit green light, and a blue light-emitting element configured to emit blue light. A wall is provided around a light-emitting element selected from the red light-emitting element, the green light-emitting element, and the blue light-emitting element, so as to control light emitting from the selected light-emitting element.

A display device according to another embodiment of the present disclosure includes a substrate; a plurality of interconnects disposed on the substrate; and a plurality of light-emitting elements arranged on the substrate and electrically connected to the plurality of interconnects. The plurality of light-emitting elements include a red light-emitting element configured to emit red light, a green light-emitting element configured to emit green light, and a blue light-emitting element configured to emit blue light. A light-transmissive part covering at least a top portion of a light-emitting element selected from the red light-emitting element, the green light-emitting element, and the blue light-emitting element is provided, and the light-transmissive part controls light emitting from the selected light-emitting element.
FIGS. 1A and 1B are drawings illustrating a problem of a related-art micro LED display;
FIG. 2 is a schematic perspective view of a substrate on which related-art micro LEDs are mounted;
FIG. 3 is a drawing illustrating the directivities of R, G, and B micro LEDs;
FIG. 4 is a block diagram illustrating an electrical configuration of a display device according to an embodiment of the present disclosure;
FIG. 5 is a diagram illustrating an electrical connection relationship between micro LEDs and substrate interconnects according to an embodiment;
FIGS. 6A and 6B are drawings illustrating a configuration of a display device according to a first embodiment of the present disclosure, and FIG. 6A is a schematic perspective view of a micro LED substrate and FIG. 6B is a schematic cross-sectional view taken along the line A1-A1 of FIG. 6A;
FIGS. 7A and 7B are drawings illustrating a configuration of a display device according to a second embodiment of the present disclosure, with FIG. 7A being a schematic perspective view of a micro LED substrate and FIG. 7B being a schematic cross-sectional view taken along the line A2-A2 of FIG. 7A;
FIGS. 8A, 8B and 8C are drawings illustrating an example of a process of manufacturing the display device according to the second embodiment of the present disclosure;
FIGS. 9A,9B, 9C and 9D are drawings illustrating a display device according to a modification of the second embodiment;
FIGS. 10A and 10B are drawings illustrating a configuration of a display device according to a third embodiment of the present disclosure, with FIG. 10A being a schematic perspective view of a micro LED substrate and FIG. 10B being a schematic cross-sectional view taken along the line A3-A3 of FIG. 10A;
FIGS. 11A, 11B, 11C and 11D are drawings illustrating a configuration of a display device according to a fourth embodiment of the present disclosure and a process of manufacturing the display device; and
FIGS. 12A,12B, 12C, 12D and 12E are drawings illustrating a configuration of a display device according to a fifth embodiment of the present disclosure and a process of manufacturing the display device.

FIG. 3 is a drawing illustrating the directivities of R, G, and B micro LEDs. A vertical line in FIG. 3 represents the intensity in the vertical direction (or the optical axis direction) of each of the micro LEDs. When the directivities of the R, G, and B micro LEDs are compared, the directivities of the G and B micro LEDs are high in an oblique direction (a direction of approximately 45 degrees) as compared to the directivity of the R micro LED. For this reason, when the user views the display from the front, a clear image can be seen, but when the user changes the viewing angle and views the display in the oblique direction, the image looks more blue and green.

In view of the above, it is desirable to provide a display device that can suppress a color change due to a viewing angle when R, G, and B light-emitting elements having different directivities are used.

A display device according to one embodiment of the present disclosure includes a substrate; a plurality of interconnects disposed on the substrate; and a plurality of light-emitting elements arranged on the substrate and electrically connected to the plurality of interconnects. The plurality of light-emitting elements include a red light-emitting element configured to emit red light, a green light-emitting element configured to emit green light, and a blue light-emitting element configured to emit blue light. A wall is provided around a light-emitting element selected from the red light-emitting element, the green light-emitting element, and the blue light-emitting element, so as to control light emitting from the selected light-emitting element.

In one embodiment, the wall reflects or absorbs a portion of the light emitted from the selected light-emitting element. In one embodiment, the wall has a top portion higher than a light exit surface of the selected light-emitting element. In one embodiment, the wall controls light emitted from the selected light-emitting element and spreading in a given direction. In one embodiment, one of the plurality of interconnects includes a ring-shaped interconnect in a region where the selected light-emitting element is to be mounted, the selected light-emitting element is disposed in a space at the center of the ring-shaped interconnect, and the wall is provided on the ring-shaped interconnect. In one embodiment, the plurality of interconnects each include a pad, an electrode of the selected light-emitting element is connected to the pad, and the wall is provided in a region of the pad where the selected light-emitting element is not mounted. In one embodiment, the display device includes an electrically-conductive adhesive between the pad and the electrode, wherein the wall is formed by pressing the electrically-conductive adhesive.

A display device according to another embodiment of the present disclosure includes a substrate; a plurality of interconnects disposed on the substrate; and a plurality of light-emitting elements arranged on the substrate and electrically connected to the plurality of interconnects. The plurality of light-emitting elements include a red light-emitting element configured to emit red light, a green light-emitting element configured to emit green light, and a blue light-emitting element configured to emit blue light. A light-transmissive part covering at least a top portion of a light-emitting element selected from the red light-emitting element, the green light-emitting element, and the blue light-emitting element is provided, and the light-transmissive part controls light emitting from the selected light-emitting element.

In one embodiment, the light-transmissive part causes light emitted from the selected light-emitting element and emitted in a given direction to be refracted toward a vertical direction or an optical axis direction. In one embodiment, the selected light-emitting element and the light-transmissive part are transferred from a stamp head.

According to one embodiment of the present disclosure, a color change due to a viewing angle can be suppressed by providing the wall for controlling light emitted from a selected light-emitting element or a light-transmissive part covering at least a portion of the selected light-emitting element.

The present disclosure relates to a display device including a substrate and a plurality of light-emitting elements formed on the substrate, and in particular, the present disclosure suppresses a color change due to a viewing angle of a display using R, G, and B micro LEDs having different directivities. The drawings referred to in following description include exaggerated representations to facilitate understanding of the present disclosure and do not represent the actual shape or scale of the product.

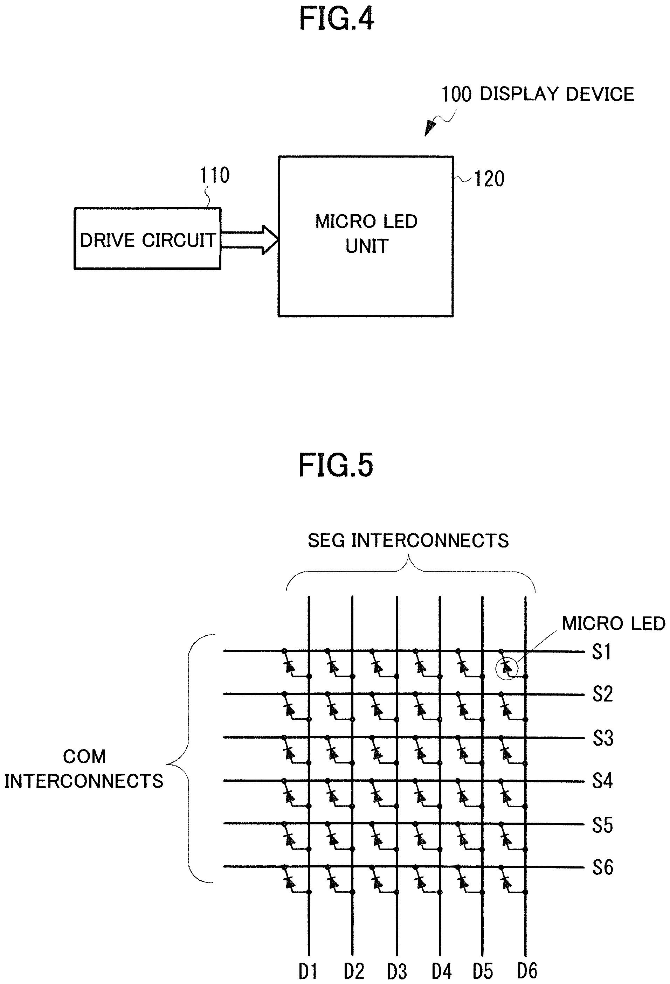

FIG. 4 is a block diagram illustrating an electrical configuration of the display device according to an embodiment of the present disclosure. As illustrated in FIG. 4, a display device 100 includes a drive circuit 110 and a micro LED unit 120 driven by the drive circuit 110.

FIG. 5 is a diagram illustrating an electrical connection relationship between micro LEDs and substrate interconnects in the micro LED unit 120. As illustrated in FIG. 5, a plurality of COM interconnects S1, S2, ..., S5, and S6 extending in the row direction (X direction) and a plurality of SEG interconnects D1, D2, ..., D5, and D6 extending in the column direction (Y direction) are formed on the substrate, and micro LEDs are disposed at intersections of the COM interconnects and the SEG interconnects. In this example, 6 × 6 passive drive COM and SEG interconnects are illustrated for convenience; however, the number of COM interconnects and SEG interconnects formed in practice corresponds to the number of pixels. The micro LED unit 120 is not limited to a passive drive micro LED unit, and may be an active drive micro LED unit. In the case of the active drive micro LED unit, switching elements are formed at the intersections of the COM interconnects and the SEG interconnects.

Although the COM interconnects and the SEG interconnects are illustrated linearly, the shape and the pattern of the interconnects are appropriately determined according to the positions of anode electrodes/cathode electrodes of the micro LEDs. The COM interconnects are electrically insulated from the SEG interconnects. For example, the COM interconnects and the SEG interconnects may be composed of a multilayer wiring structure, or the COM interconnects and the SEG interconnects may be insulated from each other by an insulating layer in regions where the COM interconnects and the SEG interconnects intersect. At the intersections of the COM interconnects and the SEG interconnects, for example, cathode electrodes of the micro LEDs are electrically connected to the COM interconnects, and anode electrodes of the micro LEDs are electrically connected to the SEG interconnects.

In a case where the micro LED unit 120 displays a color image, one pixel is composed of three sub-pixels that generate R (red), G (green), and B (blue). The R, G, and B sub-pixels are configured with, for example, a red light-emitting diode, a green light-emitting diode, and a blue light-emitting diode.

One micro LED is configured with a chip having a size of several tens of µm. For example, in a case where the micro LED unit 120 is a full high definition (HD) display, the HD display has 1920 × 1080 pixels, and the number of LED chips to be mounted is 1920 × 1080 × 3 (RGB), that is, approximately 6.22 million.

Examples of a method of mounting micro LEDs include a chip mounting method and a wafer bonding method. In the chip mounting method, individual LED chips, cut out from a semiconductor wafer, are produced, and each of the LED chips is mounted on a substrate on which interconnects and a drive circuit are formed. In the wafer bonding method, a semiconductor wafer on which LEDs are formed is directly bonded to a silicon wafer on which interconnects and drive circuits are formed.

The drive circuit 110 drives the micro LED unit 120 in a passive manner or an active manner according to image data, applies a drive current according to the image data from the SEG interconnects to the COM interconnects, and causes each of the micro LEDs to emit light.

### [Embodiments]

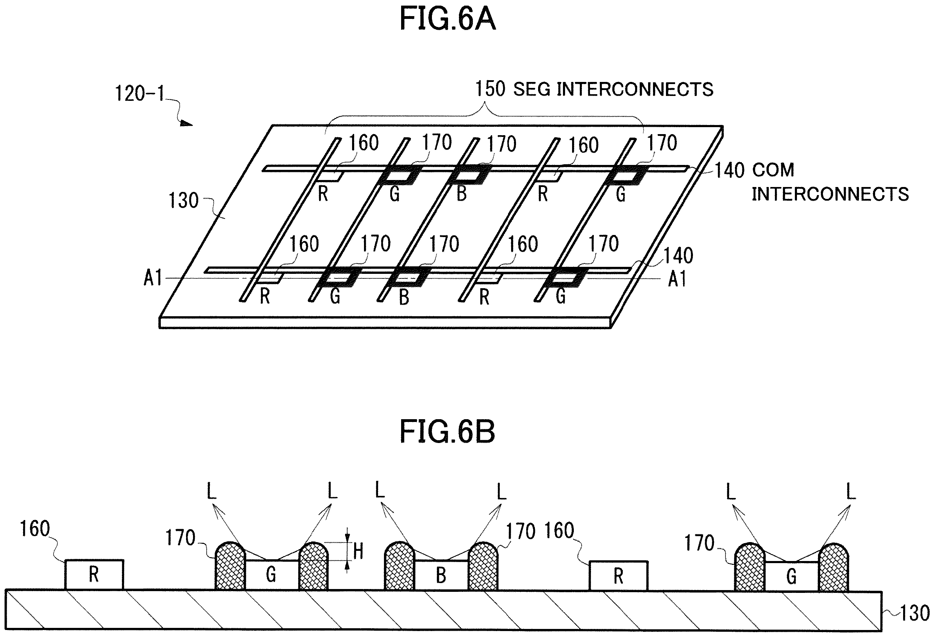

Next, embodiments of the present disclosure will be described. FIGS. 6A and 6B are drawings illustrating a configuration of a display device according to a first embodiment of the present disclosure. FIG. 6A is a schematic perspective view of a micro LED substrate. FIG. 6B is a schematic cross-sectional view taken along the line A1-A1 of FIG. 6A (cross sections of SEG interconnects are not depicted).

A micro LED unit 120-1 includes a micro LED substrate 130 having a substantially rectangular shape. The micro LED substrate 130 is, for example, a light-transmissive transparent substrate or transparent film such as glass, plastic, or acrylic, or a semiconductor substrate such as silicon. In a case where the micro LED substrate 130 is a transparent substrate, the transparent substrate can be bonded onto a semiconductor substrate on which the driving circuit 110 is formed. In a case where the micro LED substrate 130 is a silicon substrate, the drive circuit 110 may be formed on the silicon substrate.

A plurality of COM interconnects 140 extending in the row direction and a plurality of SEG interconnects 150 extending in the column direction are formed on the surface of the substrate 130. The COM interconnects 140 and the SEG interconnects 150 are electrically connected to the drive circuit 110. A material used for the substrate interconnects is not particularly limited, but is, for example, a metal material such as Cu or a light-transmissive electrically-conductive material such as ITO. Such an electrically-conductive material deposited on the substrate is patterned so as to form the COM interconnects 140 and the SEG interconnects 150.

R, G, and B micro LEDs 160 are mounted at intersections of the COM interconnects 140 and the SEG interconnects 150. The R, G, and B micro LEDs 160 are, for example, rectangular-shaped LED chips cut out from a wafer, and are arranged in the order of R, G, and B in the row direction. Each of the micro LEDs 160 includes a p-type semiconductor layer and an n-type semiconductor layer, and an anode electrode electrically connected to the p-type semiconductor layer is electrically connected to a corresponding SEG interconnect 140 and a cathode electrode electrically connected to the n-type semiconductor layer is electrically connected to a corresponding COM interconnect 150. Upon a drive current being applied between the anode electrode and the cathode electrode, each of the R, G, and B micro LEDs 160 emits red, green, or blue light from its top portion (light-emitting surface). The R, G, and B micro LEDs 160 may be referred to as micro LEDs 160R, 160G, and 160B, respectively, or the R, G, and B micro LEDs 160 may be correctively referred to as micro LEDs 160.

The micro LED unit 120-1 further includes walls 170 surrounding the outer peripheries of the respective rectangular-shaped micro LEDs 160G and 160B. The walls 170 are composed of a material that absorbs or reflects light emitted from the micro LEDs 160G and 160B. A method of manufacturing the walls 170 is not particularly limited. For example, after the micro LEDs 160 are mounted on the substrate or before the micro LEDs 160 are mounted on the substrate, a black photosensitive resin is applied onto the substrate and is patterned by a photolithography process, thereby forming the walls 170 in a grid pattern.

Each of the walls 170 is formed to be higher, by a height H, than the light-emitting surface, that is, the top portion of a corresponding micro LED 160G or 160B, thereby controlling light L emitted from the micro LED 160G or 160B and spreading in a given direction. That is, the possibility that light, emitted from the micro LED 160G or 160B having a directivity in a given direction, spreads in the given direction can be reduced. For example, unlike the micro LEDs 160R, in a case where the micro LED 160G or 160B emits light in a direction of approximately 45 degrees as illustrated in FIG. 3, each of the walls 170 absorbs or reflects the light L emitted from the micro LED 160G or 160B and spreading in the direction of approximately 45 degrees, and thus can control the spread of the light emitted from the micro LED 160G or 160B.

As described above, according to the present embodiment, the walls 170 for controlling the spread of light in a given direction are provided on the outer peripheries of respective micro LEDs 160G and 160B. Accordingly, a color change due to the viewing angle of the micro LED display can be suppressed, and a high-quality image with a small color change can be provided.

In the above-described embodiment, the spread of light from G and B is controlled with respect to R, but this is merely an example. For example, if the directivities of R, G, and B are different from those illustrated in FIG. 3, the spread of light from R and B can be controlled with respect to G, the spread of light from R and G can be controlled with respect to B, the spread of light from B can be controlled with respect to R and G, or the spread of light from G can be controlled with respect to R and B. In any of the above cases, walls are provided on the outer peripheries of micro LEDs such that the spread of light from the micro LEDs is controlled.

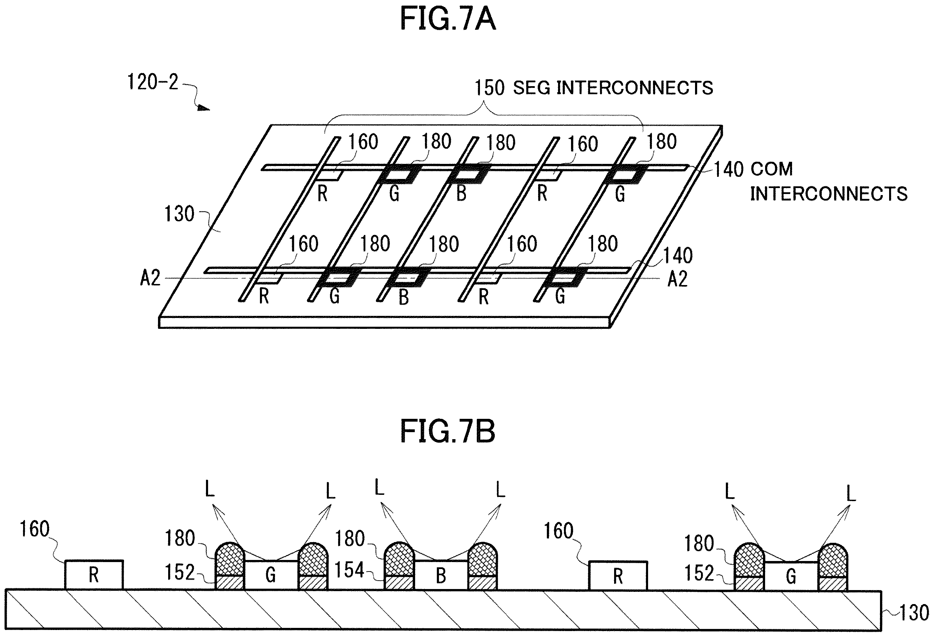

Next, a second embodiment of the present disclosure will be described. FIGS. 7A and 7B are drawings illustrating a configuration of a display device according to the second embodiment of the present disclosure. FIG. 7A is a schematic perspective view of a micro LED substrate, and FIG. 7B is a schematic cross-sectional view taken along the line A2-A2 of FIG. 7A (cross sections of SEG interconnects are not depicted).

In a micro LED unit 120-2 according to the second embodiment, a ring-shaped interconnect 152 obtained by extending an SEG interconnect 150 is formed on the outer periphery of a corresponding micro LED 160G or 160B at an intersection of a COM intersect 140 and the SEG interconnect 150. The ring-shaped interconnect 152 has a rectangular shape and surrounds the outer periphery of the corresponding micro LED 160G or 160B. The micro LED 160G or 160B is disposed in a space at the center of the ring-shaped interconnect 152, and a walls 180 is formed on the ring-shaped interconnect 152.

By forming ring-shaped interconnects 152, when COM interconnects 140 and SEG interconnects 150 are turned black, walls 180 can be easily formed at a same time when the ring-shaped interconnects 152 are turned black. Similar to the first embodiment, the walls 180 control light emitted from the micro LEDs 160G and 160B and spreading in a given direction.

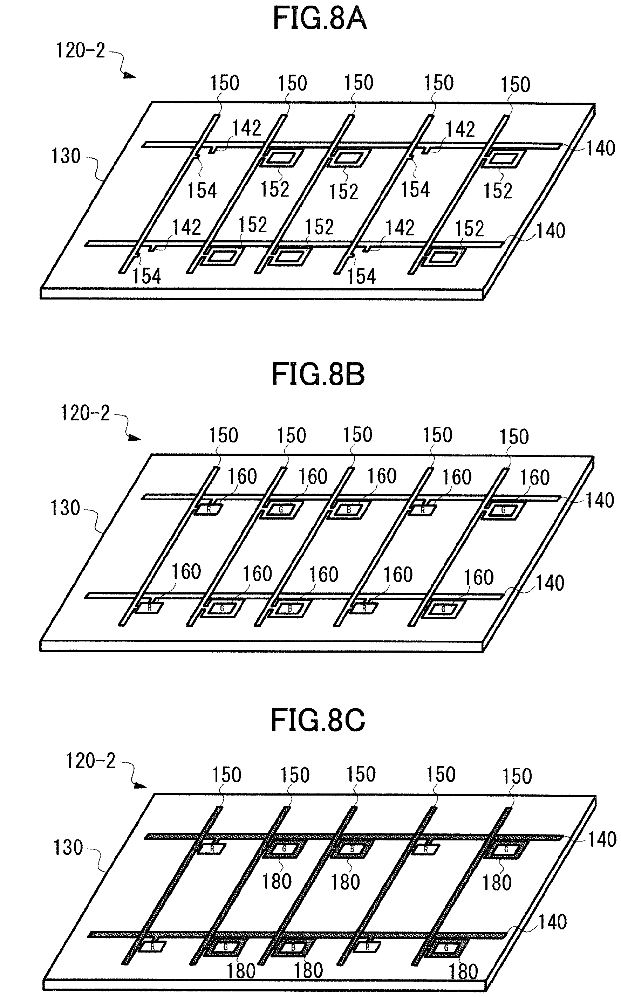

FIGS. 8A to 8C are drawings illustrating an example of a process of manufacturing the micro LED unit according to the second embodiment illustrated in FIG. 7. First, as illustrated in FIG. 8A, a pattern of a plurality of COM interconnects 140 extending in the row direction is formed on a substrate 130. At this time, protrusions 142 for electrical connection to cathode electrodes of micro LEDs 160R, G, and B are formed on the COM interconnects 140. Subsequently, an insulating film or an insulating member for electrical insulation from the COM interconnects 140 is formed, and then a pattern of a plurality of SEG interconnects 150 extending in the column direction are formed. At this time, ring-shaped interconnects 152 for electrical connection to anode electrodes of micro LEDs 160G and 160B are formed on the SEG interconnects 150. Further, protrusions 154 for electrical connection to anode electrodes of micro LEDs 160R are formed on the SEG interconnects 150.

Next, as illustrated in FIG. 8B, the micro LEDs 160 are mounted at intersections of the COM interconnects 140 and the SEG interconnects 150.
The cathode electrodes of the micro LEDs 160R are electrically connected to protrusions 142, and the anode electrodes of the micro LEDs 160R are electrically connected to the protrusions 154. The micro LEDs 160G and 160B are positioned in openings at the center of the ring-shaped interconnects 152, and the cathode electrodes of the micro LEDs 160G and 160B are electrically connected to protrusions 142, and the anode electrodes of the micro LEDs 160G and 160B are electrically connected to the ring-shaped interconnects 152.

Next, a photosensitive film in which a release film (PET) and a black photosensitive resin (positive type) are laminated is attached to the entire surface of the transparent substrate 130 including the COM interconnects 140 and the SEG interconnects 150. Next, the photosensitive film is exposed from the rear surface side of the transparent substrate 130 by using the COM interconnects 140 and the SEG interconnects 150 as a mask, and the photosensitive film is developed. Then, as illustrated in FIG. 8C, an unexposed black photosensitive film is left only on the COM interconnects 140 and the SEG interconnects 150, and the left photosensitive film is heated and cured, thereby forming walls 180. The walls 180 can be formed with a desired height by appropriately selecting the thickness of the photosensitive film.

As described above, according to the present embodiment, the walls 180 can be easily manufactured in a self-alignment manner at a time when the substrate interconnects are turned black by using a photolithography process. In the above-described embodiment, the ring-shaped interconnects 152 are formed on the SEG interconnects 150. However, alternatively, ring-shaped interconnects may be formed on the COM interconnects 140.

Next, a modification of the second embodiment will be described. In the second embodiment, an example in which the ring-shaped interconnects are formed has been described. In the modification, pads each having a relatively large mounting area are used instead of the ring-shaped interconnects.

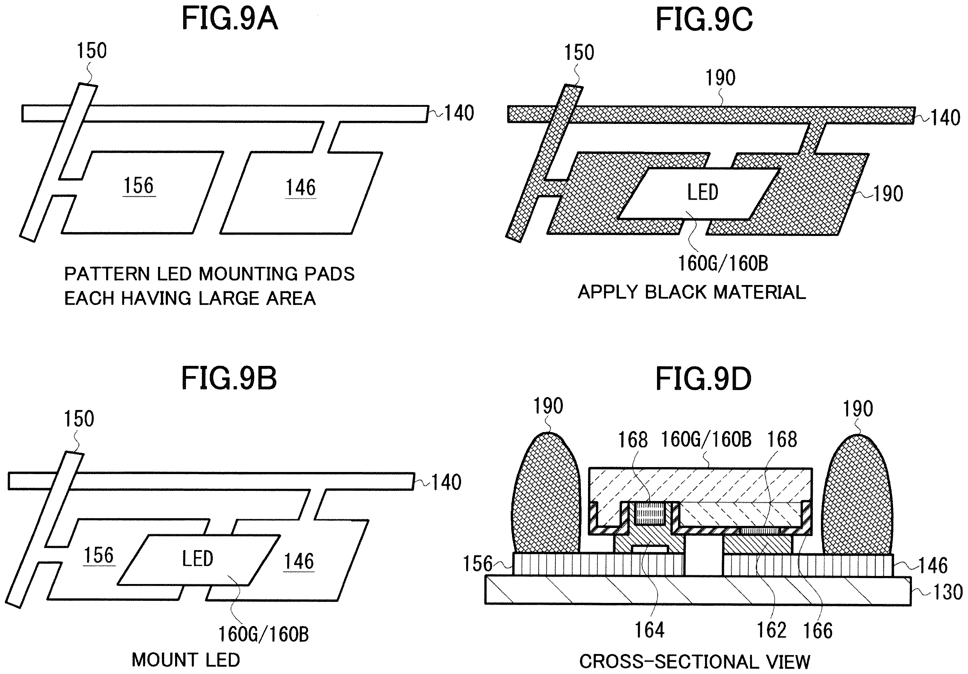

FIGS. 9A to 9D are drawings illustrating an example of a micro LED substrate and a process of manufacturing the micro LED substrate according to the modification. As illustrated in FIG. 9A, when COM interconnects 140 are patterned, a rectangular-shaped pad 146 having a relatively large area is formed at each intersection where a micro LED 160G or 160B is mounted, and when SEG interconnects 150 are patterned, a rectangular-shaped pad 156 having a relatively large area is formed at each intersection. A pad having a normal size is formed at each intersection where a micro LED 160R is mounted.

Next, as illustrated in FIG. 9B, the micro LED 160G or 160B is mounted on the pads 146 and 156. As illustrated in a cross-sectional view of FIG. 9D, the micro LED 160G or 160B includes a cathode electrode 162 and an anode electrode 164 on the bottom surface thereof. The cathode electrode 162 is electrically connected to an n-type semiconductor layer via an electrically conductive member 168 formed in an opening of an insulating film 166. Similarly, the anode electrode 164 is electrically connected to a p-type semiconductor layer via an electrically conductive member 168 formed in an opening of the insulating film 166. Accordingly, the cathode electrode 162 is electrically connected to a corresponding COM interconnect 140 via the pad 146, and the anode electrode 164 is electrically connected to a corresponding SEG interconnect 150 via the pad 156.

Next, similar to the second embodiment, a black or gray photosensitive film printed on the transparent substrate is patterned by a photolithography process, and as illustrated in FIG. 9C, a wall 190 printed in black are formed on the COM interconnect 140, the SEG interconnect 150, and the pads 146 and 156. By making the interval between the pad 146 and the pad 156 as small as possible, the wall 190 can be formed so as to substantially surround the outer periphery of the micro LED 160G or 160B without a gap.

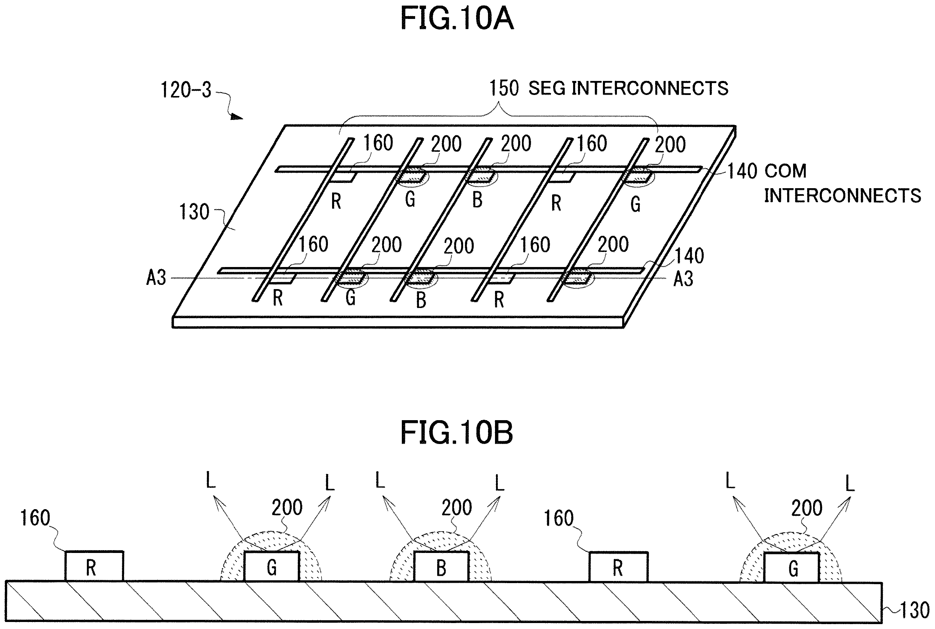

Next, a third embodiment of the present disclosure will be described. FIGS. 10A and 10B are drawings illustrating a configuration of a display device according to the third embodiment of the present disclosure. FIG. 10A is a schematic perspective view of a micro LED substrate. FIG. 10B is a schematic cross-sectional view taken along the line A3-A3 of FIG. 10A (cross sections of SEG interconnects are not depicted).

In the third embodiment, each of micro LEDs 160G and 160B having a directivity in a given direction is covered by a transparent protective material 200 so as to control light emitted from the micro LEDs 160G and 160B and spreading in the given direction.

As the transparent protective material 200 is formed by using a material having a selected refractive index and/or a protruding curved shape so as to produce a lens effect of causing light L emitted from the exit surface of each of the micro LEDs 160G and 160B to be refracted toward the vertical direction. In one aspect, the transparent protective material 200 is formed of an acrylic resin. In this case, a liquid resin is potted so as to cover each of the micro LEDs 160G and the 160B, and is then cured and hardened. In another aspect, the entire surface of a substrate 130 including COM interconnects 140 and SEG interconnects 150 is coated by a transparent liquid photosensitive resin (for example, a negative type resin containing a siloxane polymer and a solvent), and the transparent photosensitive resin is left only in a region covering the micro LEDs 160G and 160B by using a photolithography process.

According to the third embodiment, providing the transparent protective material 200 so as to cover each of the micro LEDs 160G and 160B can cause light emitted from the micro LED 160G and the 160B and , spreading in a given direction to be refracted toward the vertical direction or the optical axis direction. As a result, a color change due to the viewing angle of the micro LED display can be suppressed.

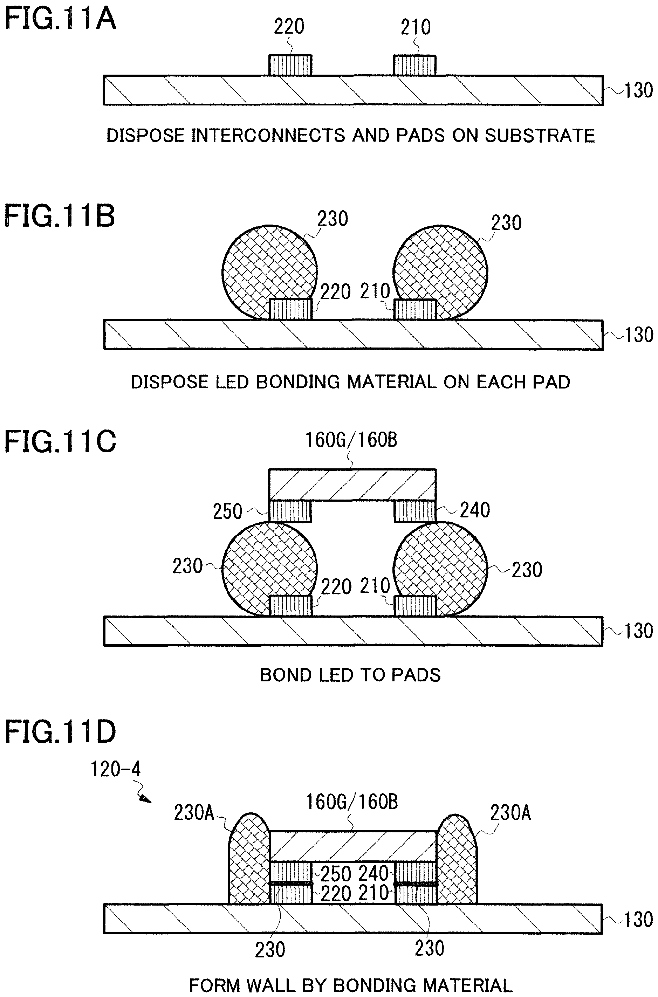

Next, a fourth embodiment of the present disclosure will be described. The fourth embodiment relates to a method of manufacturing a micro LED unit as described in the first embodiment or the second embodiment. FIGS. 11A to 11D are drawings illustrating a configuration of a micro LED unit according to the fourth embodiment and a process of manufacturing the micro LED unit.

First, as illustrated in FIG. 11A, pads 210 and 220 are formed on a substrate 130. The pads 210 and 220 are disposed at each intersection of a COM interconnect 140 and an SEG interconnect 150. For example, the pad 210 is patterned at the same time as the COM interconnect 140, and the pad 220 is patterned at the same time as the SEG interconnect 150.

Next, as illustrated in FIG. 11B, for example, a ball-shaped LED bonding material 230 is formed so as to cover each of the pads 210 and 220 on which a micro LED 160G or 160B is to be mounted. The LED bonding material 230 is, for example, silver paste or an electrically-conductive adhesive. The LED bonding material 230 is preferably formed so as to cover the surface of each of the pads 210 and 220 while ensuring that the pads 210 and 220 do not get too close to each other.

Next, as illustrated in FIG. 11C, a cathode electrode 240 and an anode electrode 250 of the micro LED 160G or 160B are aligned with the pad 210 and the pad 220, respectively. Then, the micro LED 160G or 160B is pressed toward the substrate 130 such that the cathode electrode 240 and the anode electrode 250 are respectively bonded to the pad 210 and the pad 220. As illustrated in FIG. 11D, the pressed LED bonding material 230 causes the cathode electrode 240 and the pad 210 to be bonded together and the anode electrode 250 and the pad 220 to be bonded together, and also causes each of the pads 210 and 220 to protrude outward, thereby forming a wall 230A. Subsequently, the LED bonding material 230 is heated (cured) at a constant temperature and is hardened. In this manner, a micro LED substrate 120-4 in which the wall 230A is formed by the LED bonding material 230 can be obtained.

According to the fourth embodiment, the bonding between the electrodes of the micro LED and the substrate interconnects can be utilized to form the wall 230A that substantially surrounds the outer periphery of the micro LED 160G or 160B.

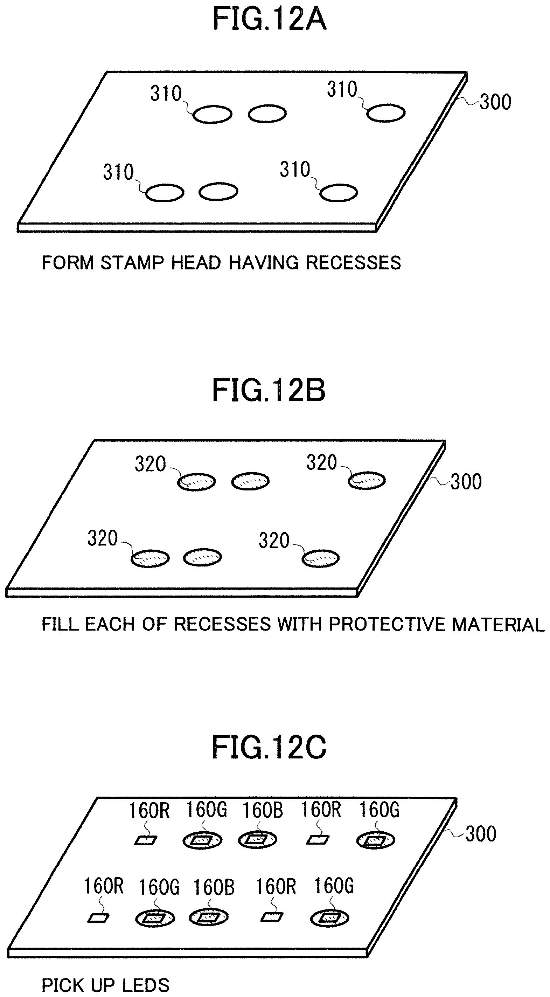

Next, a fifth embodiment of the present disclosure will be described. The fifth embodiment relates to a method of manufacturing a micro LED unit as described in the third embodiment. FIGS. 12A to 12E are drawings illustrating a configuration of a micro LED unit according to the fifth embodiment and a process of manufacturing the micro LED unit.

First, as illustrated in FIG. 12A, a stamp head 300 having recesses 310 at positions where micro LEDs 160G and 160B are to be mounted is prepared. The bottom surfaces of the recesses 310 include, for example, curved surfaces. Next, as illustrated in FIG. 12B, each of the recesses 310 of the stamp head 300 is filled with a transparent liquid protective material 320.

Next, as illustrated in FIG. 12C, micro LEDs R, G, and B 160 are picked up and placed on the stamp head 300. The micro LEDs 160G and 160B are disposed in the recesses 310, and the micro LEDs 160R are disposed on the surface of the stamp head 300 via a releasable adhesive. The micro LEDs 160 are arranged on the stamp head 300 in a state of being reversed such that cathode electrodes and anode electrodes on the back surfaces of the micro LEDs 160 are exposed. Subsequently, the protective material 320 is cured and hardened at a certain temperature.

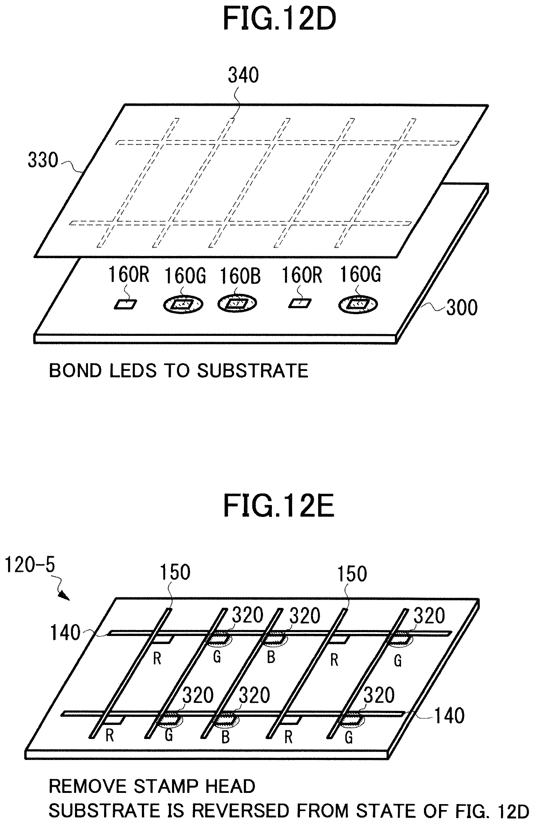

Next, as illustrated in FIG. 12D, the stamp head 300 is caused to face a substrate 330 including interconnects and a pad 340 formed on the back surface thereof, and the cathode electrodes and the anode electrodes of the micro LEDs 160 on the stamp head 300 are bonded to the pad of the substrate 330. In this case, a silver paste or an electrically-conductive adhesive may be formed on the surface of the pad so as to achieve good bonding between the electrodes and the pad.

Next, the stamp head 300 is removed, and the protective material 320 is separated from the recesses 310 of the stamp head 300. As a result, as illustrated in FIG. 12E, a micro LED unit 120-5 in which the micro LEDs 160G and 160B are each covered by a transparent protective member 320 is manufactured. FIG. 12E illustrates a state in which the substrate is reversed from the state of FIG. 12D.

According to the fifth embodiment, the thickness and the outer shape of the protective member 320 covering each of the micro LEDs can be manufactured with higher accuracy by utilizing the recesses 310 of the stamp head 300.

In each of the above-described embodiments, micro LEDs are arranged in the row direction in the order of R, G, and B, but this is merely an example, and the order is not particularly limited. Further, although a passive drive micro LED substrate has been exemplified, the present invention is not limited thereto, and an active drive micro LED substrate may be used. Further, in each of the above-described embodiments, an example in which the directivity of micro LEDs G and B is controlled with respect to that of micro LEDs R has been described; however, the present invention is not limited thereto. Needless to say, the directivity of micro LEDs can be controlled with respect to the directivity of any other micro LEDs by utilizing walls in the same manner.

Although embodiments have been described in detail above, the above-described embodiments are non-limiting examples, and various modifications and substitutions can be made to the above-described embodiments without departing from the scope of the claims.

## Claims

1. A display device comprising:
a substrate;
a plurality of interconnects disposed on the substrate; and
a plurality of light-emitting elements arranged on the substrate and electrically connected to the plurality of interconnects, wherein
the plurality of light-emitting elements include a red light-emitting element configured to emit red light, a green light-emitting element configured to emit green light, and a blue light-emitting element configured to emit blue light, and
a wall around a light-emitting element selected from the red light-emitting element, the green light-emitting element, and the blue light-emitting element, so as to control light emitting from the selected light-emitting element.

2. The display device according to claim 1, wherein the wall is configured to reflect or absorb a portion of the light emitted from the selected light-emitting element.

3. The display device according to claim 1 or 2, wherein the wall has a top portion higher than a light exit surface of the selected light-emitting element.

4. The display device according to one of claims 1 to 3, wherein the wall is configured to control light emitted from the selected light-emitting element and spreading in a given direction.

5. The display device according to one of claims 1 to 4, wherein one of the plurality of interconnects includes a ring-shaped interconnect in a region where the selected light-emitting element is to be mounted, the selected light-emitting element is disposed in a space at a center of the ring-shaped interconnect, and the wall is provided on the ring-shaped interconnect.

6. The display device according to one of claims 1 to 5, wherein the plurality of interconnects each include a pad, an electrode of the selected light-emitting element is connected to the pad, and the wall is provided in a region of the pad where the selected light-emitting element is not mounted.

7. The display device according to claim 6, further comprising an electrically-conductive adhesive between the pad and the electrode, wherein
the wall is formed by pressed electrically-conductive adhesive.

8. A display device comprising:
a substrate;
a plurality of interconnects disposed on the substrate; and
a plurality of light-emitting elements arranged on the substrate and electrically connected to the plurality of interconnects, wherein
the plurality of light-emitting elements include a red light-emitting element configured to emit red light, a green light-emitting element configured to emit green light, and a blue light-emitting element configured to emit blue light, and
a light-transmissive part covering at least a top portion of a light-emitting element selected from the red light-emitting element, the green light-emitting element, and the blue light-emitting element, and the light-transmissive part is configured to control light emitting from the selected light-emitting element.

9. The display device according to claim 8, wherein the light-transmissive part is configured to cause light emitted from the selected light-emitting element and spreading in a given direction to be refracted toward a vertical direction or an optical axis direction.

10. The display device according to claim 8 or 9, wherein the selected light-emitting element and the light-transmissive part are transferred from a stamp head.
